(19) **Europäisches Patentamt / European Patent Office / Office européen des brevets**

(11) **EP 4 715 022 A1**

(12) **EUROPEAN PATENT APPLICATION**
published in accordance with Art. 153(4) EPC

(43) Date of publication:
**25.03.2026 Bulletin 2026/13**

(21) Application number: **24877154.5**

(22) Date of filing: **07.10.2024**

(51) International Patent Classification (IPC):
*C09K 3/14* (2006.01)    *B24B 37/00* (2012.01)
*C09G 1/02* (2006.01)    *H01L 21/304* (2006.01)

(52) Cooperative Patent Classification (CPC):
**B24B 37/00; C09G 1/02; C09K 3/14; H10P 52/00**

(86) International application number:
**PCT/JP2024/035804**

(87) International publication number:
**WO 2025/079559 (17.04.2025 Gazette 2025/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.10.2023 JP 2023177602**

(71) Applicant: **Daiichi Kigenso Kagaku Kogyo Co.,
Ltd.
Osaka-shi, Osaka 541-0041 (JP)**

(72) Inventors:
• **TAKASAKI, Fumiyuki
Osaka-shi, Osaka 559-0025 (JP)**
• **ASAHI, Kiyoaki
Osaka-shi, Osaka 559-0025 (JP)**

(74) Representative: **Vossius & Partner
Patentanwälte Rechtsanwälte mbB
Siebertstraße 3
81675 München (DE)**

(54) **DISPERSION FOR POLISHING**

(57)    A dispersion for polishing containing a zirconium oxide and a polishing aid, wherein the zirconium oxide comprises a monoclinic phase and has a ratio of crystallite size of a monoclinic (-111) side to a monoclinic (111) side ((-111) side / (111) side) of from 0.50 to 0.95. The dispersion for polishing and the powder for polishing of the present invention can be used in a chemical mechanical polishing (CMP) such as a SiC wafer, and can be utilized in a production process of a semiconductor and the like.

EP 4 715 022 A1

## Description

### TECHNICAL FIELD

The present invention relates to a dispersion for polishing containing a zirconium oxide.

### BACKGROUND ART

A polishing is widely used in a microelectronics industry. SiC (silicon carbide) and the like are excellent in a dielectric breakdown strength by 10-folds higher than that of Si and in a bandgap by 3-folds higher than that of Si, and the SiC has been recently spotlighted as a power semiconductor having high temperature and high energy efficiency. From the similar reasons, a GaN (gallium nitride), a diamond, a sapphire and the like are also spotlighted and actively developed. Although flattening and smoothening a substrate in an atomic level is required to produce a high-performance device in a good yield, these substrates are more rigid and brittle as compared to Si, chemically stable and difficult to be processed, making a cause of the lowered productivity and the increased substrate-processing cost. Conventionally, a crystal is sliced, and thereafter the crystal is subjected to a polishing in multi-steps for a long term by a CMP (ChemicalMecanical Polishing) process using diamond particles or colloidal silica particles. However, significantly large costs are expended in the point of costs of consumables and equipment, thereby incurring increased costs by several times as compared to a Si substrate. The diffusion of the power semiconductor strongly requires reduction of the costs for the process. In addition, some dispersions using zirconium oxide as a grain have been proposed.

For example, Patent Publication 1 discloses a polishing slurry characterized by containing a monoclinic zirconium oxide having a crystallite size of from 10 to 1,000 nm and average particle size of from 30 to 2,000 nm in an amount of from 1 to 20% by mass, and further containing a carboxylic acid which contains three or more carboxy groups in the molecule and a quaternary alkyl ammonium hydroxide and having pH of from 9 to 12.

Patent Publication 2 discloses a powder for polishing characterized in that the powder is a polishing agent containing a zirconium oxide particles, that both of the crystallite sizes of the zirconium oxide particles of which $2\theta$ measured by a powder X-ray diffraction are calculated based on a diffraction X-ray strength near 28.0° and a diffraction X-ray strength near 31.0° are 330Å or more, and that mean primary particle size of the zirconium oxide is 0.2 $\mu$m or more.

Patent Publication 3 discloses a slurry for a chemical mechanical polishing (CMP) which contains an aqueous liquid carrier, a transition metal oxy compound selected from oxy-nitrate, oxy-chloride, oxy-sulfate, oxy-carbonate and C2 to C10-membered oxy-alkanoate, and per-based oxidant, and discloses a SiC polishing agent slurry using a zirconia particle.

Patent Publication 4 discloses a method of producing a composition for polishing containing a zirconium oxide sol, wherein the method includes a step of baking a zirconium compound having d50 of the zirconium compound particles (provided that d50 represents a particle size meaning that the number of particles equal to or less than the particle size is 50% of total numbers of particles) of from 5 to 25 $\mu$m, and d99 of the zirconium compound particles (provided that d99 represents a particle size meaning that the number of particles equal to or less than the particle size is 99% of total numbers of particles) of 60 $\mu$m or less when the slurry of the zirconium compound is measured by a laser diffraction method at a temperature range from 400 to 1000°C, and wet-pulverizing the resulting zirconium oxide powder in an aqueous medium until d50 of the zirconium oxide particles is from 80 to 150 nm, and d99 of the zirconium oxide particles is from 150 to 500 nm when the zirconium oxide slurry is measured by a laser diffraction method.

### PRIOR ART REFERENCES

### PATENT PUBLICATIONS

Patent Publication 1: Japanese Patent Laid-Open No. 2006-324639
Patent Publication 2: WO 2012/169515
Patent Publication 3: Japanese Patent Laid-Open No. 2023-512216
Patent Publication 4: WO 2006/123562

### SUMMARY OF THE INVENTION

### PROBLEMS TO BE SOLVED BY THE INVENTION

However, since SiC and the like are rigid and difficult to be processed, further improvements in production efficacy and the like are demanded.

The present invention relates to a provision of a dispersion for polishing having excellent polishing rate and excellent surface smoothness after polishing. In addition, the present invention provides a method of producing the dispersion for polishing, a method of improving polishing rate, a method of reducing the surface roughness Ra, and a powder for polishing.

## MEANS TO SOLVE THE PROBLEMS

The present invention relates to the following [1] to [5]:

[1] A dispersion for polishing containing a zirconium oxide and a polishing aid, wherein the zirconium oxide contains a monoclinic phase and has a ratio of crystallite size of a monoclinic (-111) side to a monoclinic (111) side ((-111) side / (111) side) of from 0.50 to 0.95.

[2] A method of producing a dispersion for polishing containing a zirconium oxide and a polishing aid: including preparing a dispersion using the zirconium oxide and the polishing aid, wherein the zirconium oxide contains a monoclinic phase and has a ratio of crystallite size of a monoclinic (-111) side to a monoclinic (111) side ((-111) side / (111) side) of from 0.50 to 0.95.

[3] A method of improving a polishing rate including performing polishing using a zirconium oxide and a polishing aid, wherein the zirconium oxide contains a monoclinic phase and has a ratio of crystallite size of a monoclinic (-111) side to a monoclinic (111) side ((-111) side / (111) side) of from 0.50 to 0.95.

[4] A method of reducing a surface roughness Ra including performing polishing using a zirconium oxide and a polishing aid, wherein the zirconium oxide contains a monoclinic phase and has a ratio of crystallite size of a monoclinic (-111) side to a monoclinic (111) side ((-111) side / (111) side) of from 0.50 to 0.95.

[5] A powder for polishing containing a zirconium oxide powder, wherein the zirconium oxide powder contains a monoclinic phase and has a ratio of crystallite size of a monoclinic (-111) side to a monoclinic (111) side ((-111) side / (111) side) of from 0.50 to 0.95.

## EFFECTS OF THE INVENTION

According to the present invention, a dispersion for polishing having excellent polishing rate and having excellent surface smoothness after the polishing can be provided. In addition, a method of producing the dispersion for polishing, a method of improving a polishing rate, a method of reducing a surface roughness Ra, and a powder for polishing can be provided. The step of polishing of the conventional SiC and the like can be largely shortened by satisfying both of the high polishing rate and the low surface roughness.

## MODES FOR CARRYING OUT THE INVENTION

Conventionally, it is known that a polishing speed with a powder for polishing is generally proportional to a mean particle size of the powder for polishing. On the other hand, it is thought to be desired that the mean particle size of a polishing agent is as small as possible, in order to obtain a polished surface having a small surface roughness and having a small amount of surface defects. As a result of studying the above problems, the present inventors newly found that the above problems are solved by using a powder for polishing containing a certain zirconium oxide particle. More specifically, the present inventors newly found that both of a polishing rate and a surface smoothness after polishing can be improved by using a zirconium oxide particle having a ratio of crystallite size of a monoclinic (-111) side to a monoclinic (111) side ((-111) side / (111) side) of from 0.50 to 0.95 as a grain. Among them, a zirconium oxide particle further containing a tetragonal phase from 2.0 to 90.0% in a volume fraction and having a crystallite size of each crystalline side of from 2.0 to 100.0 nm is exemplified as a preferred embodiment. All of them can be synthesized under a wet environment and constituted by a process not requiring high temperature treatment. The mechanism is not clear but assumed to be due to the following reasons. When the ratio of crystallite size of a monoclinic (-111) side to a monoclinic (111) side ((-111) side / (111) side) is close to 1.0, it is assumed that a monoclinic crystal is in a state in which the crystal evenly grows without direction, i.e. a form close to a sphere. On the other hand, as the ratio of crystallite size of a monoclinic (-111) side to a monoclinic (111) side ((-111) side / (111) side) is smaller than 1, it is assumed that the monoclinic crystal is a cuboid and rod-shape having a larger aspect ratio. The latter cuboid and rod-shaped crystals are difficult to rotate as compared to the former spherical crystal, and consequently, it is thought that a friction resistance to a polished side increases and an effect to improve a polishing rate of a substrate is exhibited. In addition, since a cuboid and a rod-shaped particle likely take a linear or a surface contact than the spherical particle and an impact is dispersed upon a collision to a polished side, it is thought that the particle has excellent smoothness (can reduce a surface roughness).

The dispersion for polishing of the present invention contains a zirconium oxide containing a monoclinic phase and having a ratio of crystallite size of a monoclinic (-111) side to a monoclinic (111) side ((-111) side / (111) side) of from 0.50 to 0.95, and a polishing aid.

The zirconium oxide according to the present invention usually refers to a zirconium oxide containing a several percentages of hafnium oxide as an inevitable impurity, and generally refers to a zirconium oxide containing a hafnium oxide in an amount of from 1.0 to 3.0%, and may be a zirconium oxide which is purified to remove a hafnium oxide. In addition, the zirconium oxide may be a stabilized zirconium oxide, and in this case, calcium, magnesium, yttrium, cerium, other rare earth elements and the like may be dissolved as a solid therein. In addition, the zirconium oxide may contain other elements which can be dissolved as a solid. In addition, the zirconium oxide may be complexed with other oxide particles to form one particle. The zirconium oxide can function as a grain and realize high polishing rate and low surface roughness by satisfying the above requirements. The above requirements are specified by a powder X-ray diffraction measurement of powders obtained by drying the dispersion for polishing of the present invention and an analysis of the diffracted chart obtained from the measurement. The detailed conditions of the powder X-ray diffraction measurement and analysis are described later.

As a crystalline phase of the zirconium oxide, a monoclinic phase, a tetragonal phase, a cubic phase and the like are known, but the zirconium oxide of the present invention contains at least a monoclinic phase. The ratio of the monoclinic phase in the zirconium oxide of the present invention is preferably from 10 to 100%, more preferably from 10 to 90%, even more preferably from 20 to 80%, and even more preferably from 30 to 70% in a volume fraction, from the viewpoints of the polishing rate and the smoothness. The content of the crystalline phase is measured according to the method described in the following Examples.

The ratio of crystallite size of a monoclinic (-111) side to a monoclinic (111) side ((-111) side / (111) side) in the monoclinic phase is from 0.50 to 0.95, preferably from 0.52 to 0.93, more preferably from 0.54 to 0.91, even more preferably from 0.56 to 0.89, and even more preferably from 0.58 to 0.87, from the viewpoints of the polishing rate and the smoothness. The crystallite size is measured according to the method described in the following Examples.

The zirconium oxide of the present invention preferably further contains a tetragonal phase, from the viewpoint of the smoothness. The ratio of the tetragonal phase in the zirconium oxide of the present invention is preferably from 2.0 to 90.0%, more preferably from 3.0 to 80.0%, even more preferably from 4.0 to 70.0%, and even more preferably from 5.0 to 60.0% in a volume fraction, from the viewpoint of smoothness.

In an embodiment containing the above tetragonal phase, the ratio of crystallite size of a monoclinic (-111) side to a tetragonal (101) side ((-111) side / (101) side) is preferably from 0.30 to 1.20, more preferably from 0.35 to 1.15, even more preferably from 0.40 to 1.10, and even more preferably from 0.45 to 1.05, from the viewpoints of the polishing rate and the smoothness.

In an embodiment containing the above tetragonal phase, a mechanism in which the smoothness is particularly excellent is not clear, but assumed to be due to the following reasons. The tetragonal phase has a property of being subjected to a phase transition to a monoclinic phase by a pressure and accompanies with a volume expansion in several % at that time. It is perhaps thought that at least a part of the tetragonal phase is subjected to a phase transition to a monoclinic phase when exposed to a pressure at an interface between a polishing pad and a polished side, the volume expansion at that time cleaves an aggregation of crystallites to each other, and the aggregation is loosened, thereby functioning to release the above exposed pressure. As a result, it is presumed that an instantaneous pressurization to a polished side by a polishing grain which would periodically take place during the polishing is suppressed, leading to the lowering of the surface roughness. In addition, when the ratio of crystallite size of a monoclinic (-111) side to a tetragonal (101) side ((-111) side / (101) side) is from 0.30 to 1.20, it is assumed that the phase transition effect of the tetragonal crystal is more effectively exhibited.

A method of adjusting the ratio of crystallite size of a monoclinic (-111) side to a monoclinic (111) side ((-111) side / (111) side) in a monoclinic phase and crystallite size ratio of a monoclinic (-111) side to a tetragonal (101) side ((-111) side / (101) side) is not limited, but the adjustment in a production embodiment of a zirconium oxide sol described in the following Examples is explained. The method of producing the zirconium oxide sol of the present embodiment includes step A of adding ammonia water dropwise to a zirconium oxychloride aqueous solution to neutralize the solution, and step B of subjecting the zirconium hydroxide obtained in step A to a heating and aging treatment under an acidic condition. In step A, the dropwise addition of ammonia water is carried out in plural times, for example, separated into two steps. In the first step, after dropwise addition of the ammonia water equimolar to Zr in a conversion to $NH_3$, the solution is maintained for a given time of period, and then the solution is maintained for a given time of period after dropwise addition of the ammonia water as a second step. Here, the higher temperature of the zirconium oxychloride is, the larger crystallite size is, and the crystallite size ratio of a monoclinic (-111) side to a monoclinic (111) side ((-111) side / (111) side) can be increased. The crystallite size ratio ((-111) side / (111) side) can be lowered by prolonging the retention time in the above first step. A tetragonal ratio and a crystallite size ratio of a monoclinic (-111) side to a tetragonal (101) side ((-111) side / (101) side) can be lowered by prolonging the retention time in the above second step.

The crystallite size of each crystalline side of the zirconium oxide of the present invention (monoclinic (-111) side, monoclinic (111) side, tetragonal (101) side, and cubic (111) side) is preferably from 2.0 to 100.0 nm, more preferably from 3.0 to 80.0 nm, even more preferably from 4.0 to 60.0 nm, and even more preferably from 5.0 to 40.0 nm, from the viewpoints of the polishing rate and the smoothness. Here, as a crystalline side of the zirconium oxide, the monoclinic (-111) side may be expressed as m (-111), the monoclinic (111) side may be expressed as m (111), the tetragonal (101) side may be expressed as t (101) and the cubic (111) side may be expressed as c (111). In addition, since the t (101) and c (111) have the same peak position in a powder X-ray diffraction measurement, both are not distinguished and addressed as equivalent. In other words, the peaks of t (101) and c (111) are addressed as a peak of t (101) in the present invention.

The median diameter (particle size $D_{50}$) of the zirconium oxide in the dispersion for polishing of the present invention is preferably from 2.0 to 5000.0 nm, more preferably from 3.0 to 1000.0 nm, even more preferably from 4.0 to 500.0 nm, and even more preferably from 5.0 to 100.0 nm, from the viewpoints of the polishing rate and the smoothness. The median diameter (particle size $D_{50}$) is measured according to the method described in the following Examples. Here, the exhibition of the function of the present invention is thought to be main due to the properties associated with the crystallite of the zirconium oxide as described above, and therefore, the particle size of the aggregated particles is not particularly limited.

The content of the zirconium oxide in the dispersion for polishing of the present invention can be properly selected depending on a subject to be polished and a polishing condition, and usually from 0.1 to 20% by mass, and preferably from 1 to 15% by mass. In addition, as long as they do not impair the polishing property of the present invention, grains other than the zirconium oxide may be present together. The grain other than zirconium oxide includes a known inorganic particle, an organic particle and an organic-inorganic composite particle, for example, a silica particle, an alumina particle, an oxide particle such as a cerium oxide particle, a chromium oxide particle, a titanium dioxide particle, a magnesium oxide particle, a manganese dioxide particle, a zinc oxide particle, a ferrite oxide particle; a nitride particle such as a silicon nitride particle, a boron nitride particle; a carbide particle such as a silicon carbide particle, a green silicon carbide (GC) particle, a boron carbide particle; a diamond particle; and a carbonate such as calcium carbonate or barium carbonate.

In an embodiment where a grain other than the above zirconium oxide is contained, the concentration of the grain other than zirconium oxide is preferably 10% by mass or less, and more preferably 5% by mass or less, based on the concentration of all grains.

The polishing aid of the present invention is an ingredient enhancing an effect by a polishing, and a water-soluble polishing aid is preferably used. The polishing aid includes peroxide such as hydrogen peroxide; a nitrate compound such as a ferrite nitrate, a silver nitrate, an aluminum nitrate and cerium ammonium nitrate which is a complex thereof; a persulfate compound including persulfate such as potassium peroxymonosulfate, peroxydisulfate, ammonium persulfate which is a salt thereof, and potassium persulfate; a chlorine compound such as chloric acid and a salt thereof, perchlorate, potassium perchlorate; a bromine compound such as bromic acid, potassium borate which is a salt thereof; an iodine compound such as iodic acid, ammonium iodide which is a salt thereof, periodic acid, sodium periodide and potassium periodide which are a salt thereof; ferrates such as ferric acid, and potassium ferrate which is a salt thereof; permanganates such as permanganate acid, sodium permanganate and potassium permanganate which are a salt thereof; chromates such as chromic acid, potassium chromate and potassium dichromate which are a salt thereof; vanadates such as vanadic acid, ammonium vanadate, sodium vanadate, sodium metavanadate and potassium vanadate which are a salt thereof; ruthenates such as perruthenate or a salt thereof; molybdates such as molybdic acid, ammonium molybdate and disodium molybdate which are a salt thereof; rhenic acids such as perrhenate or a salt thereof; tungstic acids such as tungstic acid and disodium tungstate which are a salt thereof, and they can be used alone or in two or more kinds. Among them, an oxidizing agent is preferred, and particularly, potassium permanganate, sodium permanganate, periodic acid, potassium persulfate, hydrogen peroxide and the like are preferred, from the viewpoints of polishing efficiency and the like.

The content of the polishing aid in the dispersion for polishing of the present invention can be properly selected depending on a subject to be polished and a polishing condition, and usually from 0.1 to 20.0% by mass, and preferably from 1.0 to 10.0% by mass.

The dispersing medium of the dispersion for polishing of the present invention is not limited as long as the polishing property can be secured, and usually water, and ion exchange water, pure water, ultra-pure water, distilled water and the like can be used. In addition, the dispersion may further contain an organic solvent which can be evenly mixed with water (lower alcohol, lower ketone and the like), if necessary. The content of water in the dispersing medium is preferably 90% by volume or more, more preferably 95% by volume or more, and even more preferably 100% by volume.

The pH of the dispersion for polishing of the present invention is not limited, and can be properly, optionally adjusted to adjust an electric potential of a grain and a polished side. For example, pH can be adjusted to pH of from 0.5 to 13.5, pH of from 1.0 to 13.0, pH of from 1.5 to 12.5 and the like. The pH can be adjusted by adding a general acid (hydrochloric acid, nitric acid, sulfuric acid, phosphoric acid, acetic acid and the like) or a general base (sodium hydroxide, ammonia, amine and the like) to the dispersion for polishing.

The dispersion for polishing of the present invention may optionally contain various additives other than the above. The known additive includes, for example, a chelator, a thickener, a dispersant, a surface protective agent, a wetting agent, a pH adjuster, a surfactant, an organic acid, an organic acid salt, an inorganic acid, an inorganic acid salt, a corrosion inhibitor, a preservative, a mildewproof and the like. The kinds or concentration of these any additives is not limited at all, as long as the polishing property of the present invention is secured.

An inorganic ion such as a nitrate ion, a chloride ion and a sulfate ion, a metal ion such as sodium, potassium, ferrite and titanium, an organic ion such as an acetate ion and a tetramethyl ammonium ion, and the like may be present as an impurity in the dispersion for polishing of the present invention, but not causing problems, as long as the polishing property of the present invention is secured.

Since the dispersion for polishing of the present invention is excellent in the polishing rate and smoothness of the surface after the polishing, the dispersion can be suitably used in the polishing of the substrate such as Si, SiC, GaN, sapphire, oxide film, the metal film such as W and Cu, and the like, and particularly suitably used in the polishing of a SiC wafer. Accordingly, the present invention provides a method of improving a polishing rate and a method of reducing a surface roughness Ra including polishing using a zirconium oxide and a polishing aid, wherein the zirconium oxide contains a monoclinic phase and has a ratio of crystallite size of a monoclinic (-111) side to a monoclinic (111) side ((-111) side / (111) side) of from 0.50 to 0.95. Here, a polishing using a zirconium oxide and a polishing aid includes an embodiment where a dispersion for polishing in which a zirconium oxide and a polishing aid are previously mixed is used, and an embodiment where the polishing is carried out using them separately.

For the polishing property of the dispersion for polishing of the present invention, for example, the polishing rate in the condition of Examples described later (Si side polishing of a SiC wafer) is preferably 0.5 $\mu$m/h or more, more preferably 0.6 $\mu$m/h or more, and even more preferably 0.7 $\mu$m/h or more. A higher polishing rate is better, unless the surface roughness exceeds a certain level, and the polishing rate can be, for example, 5 $\mu$m/h or less, 3 $\mu$m/h or less and the like.

For the smoothness after the polishing using the dispersion for polishing of the present invention, for example, the surface roughness Ra in the condition of Examples described later (Si side polishing of a SiC wafer) is preferably 1.0Å or less, more preferably 0.9Å or less, and even more preferably 0.8Å or less. A smaller surface roughness Ra of the polished side is better, and for example, the surface roughness can be 0.1Å or more, 0.2Å or more, and the like.

The method of producing the dispersion for polishing of the present invention is not particularly limited, and a method of production including preparing a dispersion using a zirconium oxide and a polishing aid, wherein the zirconium oxide contains a monoclinic phase, and has a ratio of crystallite size of a monoclinic (-111) side to a monoclinic (111) side ((-111) side / (111) side) of from 0.50 to 0.95 is exemplified. In other words, the dispersion for polishing of the present invention can be produced by mixing the given zirconium oxide, the polishing aid, the dispersing medium and any additives. The manner, order and the like of mixing these ingredients are not particularly limited, as long as the physical properties of the dispersion for polishing are achieved. One example of the mixing procedure for producing the dispersion for polishing is shown. As a first step, the given zirconium oxide is dispersed as a dispersoid to a dispersing medium. The pulverizer such as beads mill may be used, depending on the demand. At that time, the concentration of zirconium oxide can be properly selected depending on a subject to be polished and a polishing condition. In addition, an acid, a base, a dispersing agent and the like can be added to assist dispersing a zirconium oxide in the first step. In the particle size distribution measurement according to the dynamic light scattering of the dispersion obtained in the first step, if the value of $D_{50}$ is from 2.0 to 5000.0 nm, the first step is considered as being completed. Next, as a second step, the dispersion for polishing can be produced by adding an oxidizing agent such as potassium permanganate and hydroxide peroxide (polishing aid), and optionally a grain other than a zirconium oxide, a general acid (hydrochloric acid, nitric acid, sulfuric acid, phosphoric acid, acetic acid and the like) and a general base (sodium hydroxide, ammonia, amine and the like) for the main purpose of adjustment of pH, a dispersing agent, agents for the other purposes, and the like to the dispersion obtained in the first step.

The powder for polishing of the present invention contains a powder of the given zirconium oxide explained above, i.e. a zirconium oxide powder containing a monoclinic phase and having a ratio of crystallite size of a monoclinic (-111) side to a monoclinic (111) side ((-111) side / (111) side) of from 0.50 to 0.95, and also the tetragonal phase ratio and the like are as described above.

The zirconium oxide powder according to the powder for polishing of the present invention can be produced by a wetting method, and has a purity of preferably from 97 to 100% by mass, more preferably from 98 to 100% by mass, and even more preferably from 99 to 100% by mass.

The mean secondary particle size of the zirconium oxide powder according to the powder for polishing of the present invention is preferably from 0.002 to 5 $\mu$m, more preferably from 0.003 to 1 $\mu$m, even more preferably from 0.004 to 0.5 $\mu$m, and even more preferably from 0.005 to 0.1 $\mu$m, from the viewpoints of the polishing rate and the smoothness. The mean secondary particle size is measured according to a general dynamic light scattering method.

The specific surface area of the zirconium oxide powder according to the powder for polishing of the present invention is preferably from 20 to 200 m$^2$/g, more preferably from 30 to 180 m$^2$/g, even more preferably from 40 to 170 m$^2$/g, and even more preferably from 50 to 160 m$^2$/g, from the viewpoints of the polishing rate and the smoothness. The specific surface area is measured according to BET method by a general nitrogen adsorption.

The content of the zirconium oxide powder according to the powder for polishing of the present invention is preferably from 97.0 to 99.9% by mass, more preferably from 98.0 to 99.5% by mass, and even more preferably from 98.5 to 99.0% by mass.

The powder for polishing of the present invention may optionally contain a grain other than the above zirconium oxide, surface modifying agent and the like.

EXAMPLES

Hereinafter, the present invention will be more particularly described by showing Examples and Comparative Examples, without intending to limit the scope of the present invention to the following Examples and Comparative Examples.

[Measurement of Particle Size $D_{50}$]

The dispersion for polishing obtained in each of Examples and Comparative Examples was diluted to 1.0% by mass in the conversion to $ZrO_2$, and the dispersions were supplied to an apparatus (Dynamic Light Scattering Method Particle Size Distribution Analyzer ("Zetasizer Nano ZS," manufactured by Malvern Panalytical)) to measure the particle size $D_{50}$ (volume frequency distribution criteria).

<Condition of Measurement>

    Measurement temperature: 25°C
    Scattering angle: 173°
    Dispersoid: $ZrO_2$
    Dispersing medium: Water
    Cell: Original Disposable Cell
    Number of repeats: 3 ($D_{50}$ is a mean of 3 times measurements)

[Powder X-ray Diffraction Measurement and Analysis]

The dispersion for polishing obtained in each of Examples and Comparative Examples dried at 100°C was measured by X-ray Diffraction Analyzer ("RINT2500," manufactured by RIGAKU), to provide X-ray diffraction chart. The chart in the range of $2\theta$ = 20 to 40° was analyzed with Powder XRD, SmartLab Studio II (RIGAKU), to calculate crystallite size and crystal phase ratio. For this calculation, three peaks of which peak tops were positioned in the ranges of 27.5 to 28.5°, 29.5 to 30.5° and 31.0 to 32.0° in the diffraction chart were selected as a subject. The ranges of 27.5 to 28.5°, 29.5 to 30.5° and 31.0 to 32.0° are respectively attributed to m (-111), t (101) or c (111), and m (111). Here, as mentioned above, peaks of t (101) and c (111) are addressed as a peak of t (101). In the case where these peak angles are out of the above ranges by the change of lattice constants due to dissolution as a solid of other elements to a zirconium oxide, even when the peaks are split, the peaks can be subjected to the analysis if the peaks are reasonable to be attributed to the above crystalline side. The tetragonal phase ratio was calculated according to the following formula, based on the diffraction peak strength I of each crystalline side obtained in the above analysis. In addition, the monoclinic phase ratio can be calculated in the same manner.

[Powder X-ray Diffraction Analysis Details]

The powder X-ray diffraction measuring data is read in a software, Powder XRD in SmartLab Studio II, and thereafter, peak treatment is performed.
Peak profiling conditions are set as follows.

    Peak search: Check box ON
    Pretreatment: Customized
    Method: Second derivative
    $\sigma$ cut value: 3 (when the clearly visible peaks are not detected, adjusted between 0.5 and 3)
    Profiling fitting: Check box ON
    Peak shape: Divided type pseudo-Voigt function
    Background type: B-spline
    Fitting condition: Auto
    Refinement of background: Check box ON

For calculation of the crystallite size and the crystallite size ratio, values shown in a column of crystallite size (Å) represented in a peak list tab (values in parentheses are disregarded) are used.

For calculation of the tetragonal ratio, values shown in a column of integral intensity (count°) represented in the peak list tab (values in parentheses are disregarded) are used.

Tetragonal Phase Ratio(%) = It (101) / {It (101) + Im (-111) + Im (111)} $\times$ 100

Measurement apparatus: X-ray Diffraction Analyzer, manufactured by RIGAKU, RINT2500
Radiation source: CuK$\alpha$ radiation source
Tube voltage: 50 kV
Tube current: 300 mA
Scanning angle: 2$\Theta$ = 10 to 50°
Scanning speed: 1°/min

[Evaluation of Polishing Property]

SiC wafer was polished using the dispersions for polishing of Examples and Comparative Examples, and a polishing rate and a surface roughness Ra of a polished side were measured. The measuring method of a polishing rate was as follows: Weights of substrates before and after of the polishing were measured, and the polishing rate was calculated from the differences. Surface roughness Ra of the polished side after polishing the subject to be polished was measured in a condition such that the viewing angle was 5.0 $\mu$m $\times$ 5.0 $\mu$m. Surface roughness Ra was measured using an atomic force microscope (AFM), manufactured by Bruker, Dimension Edge according to JIS B 0601-2001.

The polishing condition was as follows.

Substrate (subject to be polished): 4H-SiC wafer, 4 inches, Si side, Off 4°, nondoped (surface roughness Ra: about 1Å)
Polishing apparatus: Single Side Polisher, manufactured by ENGIS, EJ-380N
Polishing pad: SUBA600 (NITTA DuPont Incorporated)
Polishing load: 280 g/cm$^2$
Rotational speed of surface plate: 80 rpm (linear velocity: 9.5 m/min)
Polishing time: 2 hours
Feeding speed of composition for polishing: 10 mL/min
Measured areas of subject to be polished: 5.0 $\mu$m $\times$ 5.0 $\mu$m (surface roughness)

[Evaluation of Surface Defect]

The surface defects after polishing a subject to be polished were measured at randomly selected five points within a range of 1.0 $\times$ 1.0 mm of field using polarizing microscope (KEYENCE CORPORATION, VHX-7100), and a mean of the five points were evaluated according to the following evaluation criteria.

(Evaluation Criteria)

◎: Not detected
○: Exceeding 0 and 1 or less
△: Exceeding 1 and 2 or less
✕: Exceeding 2

(Example 1)

To 8000 g of zirconium oxychloride aqueous solution (10% by mass in a conversion to ZrO$_2$) adjusted at 60°C with a mantle heater, ammonia water was added dropwise to carry out neutralization in two steps. In the first step, 1104 g of ammonia water (10% by mass) adjusted at 25°C was supplied dropwise over 10 minutes. At that time, the number of liquid feeding tubes and addition rate were adjusted such that the volume of the drops of ammonia water was in a range of from 0.1 to 0.5 ml. Thereafter, the stirring continued for 60 minutes. Then, in the second step, 9936 g of ammonia water (10% by mass) adjusted at 25°C was added dropwise over 30 minutes, and the stirring continued for 10 minutes, to provide a precipitate of zirconium hydroxide. The zirconium oxychloride aqueous solution was adjusted to maintain the initial temperature within ±5°C even during the dropwise addition of ammonia water and during stirring after the dropwise addition. The zirconium hydroxide was filtered and separated, and again the wash procedure which dispersed zirconium hydroxide with ion exchange water was repeatedly carried out. The above procedure was carried out until the concentration of Cl was equal to or less than 0.01%. The concentration of zirconium hydroxide after wash was 24.0% by mass in a conversion to $ZrO_2$. To 3328 g of the resulting zirconium hydroxide, 4448 g of ion exchange water and 224 g of nitric acid (60% by mass) was mixed, the prepared slurry was placed into a separable flask and maintained for 120 hours at 100°C under reflux with stirring, and the resulting zirconium oxide precursor was purified using a ultrafiltration, to provide zirconium oxide sol of Example 1. The concentration of $ZrO_2$ of the sol was 20%, pH was 3.3 and $D_{50}$ was 51 nm. In addition, the specific surface area of powders obtained by drying the sol was 175 $m^2/g$. Next, to 3000 g of the zirconium oxide sol, 952 g of ion exchange water and 48 g of potassium permanganate were added, and the mixture was stirred for 30 minutes, to provide a dispersion for polishing. The powder X-ray diffraction measurement and analysis, and an evaluation of the polishing property are shown in Table 1 by combining other Examples and Comparative Examples.

(Example 2)

The zirconium hydroxide was obtained in the same manner as Example 1, except that 8000 g of zirconium oxychloride aqueous solution (10% by mass in a conversion to $ZrO_2$) adjusted at 75°C with a mantle heater was used. The concentration of the zirconium hydroxide after wash was 22.8% by mass in a conversion to $ZrO_2$. The zirconium oxide sol was obtained in the same manner as Example 1 except that 4264 g of ion exchange water was used to 3512 g of the resulting zirconium hydroxide. The concentration of $ZrO_2$ of the sol was 20%, pH was 3.1 and $D_{50}$ was 73 nm. Next, the dispersion for polishing was obtained in the same manner as Example 1 using the zirconium oxide sol.

(Example 3)

The zirconium hydroxide was obtained in the same manner as Example 1 except that 8000 g of zirconium oxychloride aqueous solution (10% by mass in a conversion to $ZrO_2$) adjusted at 90°C with a mantle heater was used. The concentration of zirconium hydroxide after wash was 21.3% by mass in a conversion to $ZrO_2$. The zirconium oxide sol was obtained in the same manner as Example 1 except that 4024 g of ion exchange water was used to the 3752 g of resulting zirconium hydroxide. The concentration of $ZrO_2$ of the sol was 20%, the pH was 3.4 and $D_{50}$ was 95 nm. Next, the dispersion for polishing was obtained in the same manner as Example 1 using the zirconium oxide sol.

(Example 4)

The zirconium hydroxide was obtained in the same manner as Example 1 except that 8000 g of zirconium oxychloride aqueous solution (10% by mass in a conversion to $ZrO_2$) adjusted at 75°C with a mantle heater was used, 1104 g of ammonia water (10% by mass) adjusted at 25°C was supplied dropwise over 10 minutes in the second step, and thereafter the stirring continued for 90 minutes. The concentration of zirconium hydroxide after wash was 22.9% by mass in a conversion to $ZrO_2$. The zirconium oxide sol was obtained in the same manner as Example 1 except that 4280 g of ion exchange water was used to 3496 g of the resulting zirconium hydroxide. The concentration of $ZrO_2$ of the sol was 20%, the pH was 3.1 and $D_{50}$ was 44 nm. Next, the dispersion for polishing was obtained in the same manner as Example 1 using the zirconium oxide sol.

(Example 5)

The zirconium hydroxide was obtained in the same manner as Example 1, except that 8000 g of zirconium oxychloride aqueous solution (10% by mass in a conversion to $ZrO_2$) adjusted at 75°C with a mantle heater was used, 9936 g of ammonia water (10% by mass) adjusted at 25°C was supplied dropwise over 30 minutes in the second step, and thereafter the stirring continued for 30 minutes. The concentration of zirconium hydroxide after wash was 23.8% by mass in a conversion to $ZrO_2$. The zirconium oxide sol was obtained in the same manner as Example 1 except that 4280 g of ion exchange water was used to 3360 g of the resulting zirconium hydroxide. The concentration of $ZrO_2$ of the sol was 20%, the pH was 3.3 and $D_{50}$ was 43 nm. Next, the dispersion for polishing was obtained in the same manner as Example 1 using the zirconium oxide sol.

(Example 6)

The zirconium hydroxide was obtained in the same manner as Example 1 except that 1000 g of zirconium oxychloride aqueous solution (10% by mass in a conversion to $ZrO_2$) adjusted at 75°C with a mantle heater was used, 9936 g of ammonia water (10% by mass) adjusted at 25°C was supplied dropwise over 30 minutes in the second step, and thereafter the stirring continued for 60 minutes. The concentration of the zirconium hydroxide after wash was 23.2% by mass in a conversion to $ZrO_2$. The zirconium oxide sol was obtained in the same manner as Example 1 except that 4328 g of ion exchange water was used to 3448 g of the resulting zirconium hydroxide. The concentration of $ZrO_2$ of the sol was 20%, the pH was 3.2 and $D_{50}$ was 39 nm. Next, the dispersion for polishing was obtained in the same manner as Example 1 using the zirconium oxide sol.

(Example 7)

The zirconium hydroxide was obtained in the same manner as Example 1 except that 1000 g of zirconium oxychloride aqueous solution (10% by mass in a conversion to $ZrO_2$) adjusted at 75°C with a mantle heater was used, 9936 g of ammonia water (10% by mass) adjusted at 25°C was supplied dropwise over 30 minutes in the second step, and thereafter the stirring continued for 120 minutes. The concentration of the zirconium hydroxide after wash was 22.6% by mass in a conversion to $ZrO_2$. The zirconium oxide sol was obtained in the same manner as Example 1 except that 4240 g of ion exchange water was used to 3536 g of the resulting zirconium hydroxide. The concentration of $ZrO_2$ of the sol was 20%, the pH was 3.3 and $D_{50}$ was 34 nm. Next, the dispersion for polishing was obtained in the same manner as Example 1 using the zirconium oxide sol.

(Comparative Example 1)

The zirconium oxychloride aqueous solution (10% by mass in a conversion to $ZrO_2$) in an amount of 1000 g which was adjusted at 25°C was used, and 11040 g of ammonia water (10% by mass) adjusted at 25°C was supplied dropwise over 40 minutes. At that time, the number of liquid feeding tubes and the drop rate were adjusted such that the volume of the droplet of ammonia water was within the range of from 0.1 to 0.5 ml. Thereafter, the stirring continued for 10 minutes, to provide a precipitate of the zirconium hydroxide. The concentration of the zirconium hydroxide after wash was 28.4% by mass in a conversion to $ZrO_2$. The zirconium oxide sol was obtained in the same manner as Example 1 except that 4960 g of ion exchange water was used to 2816 g of the resulting zirconium hydroxide. The concentration of $ZrO_2$ of the sol was 20%, the pH was 3.3 and $D_{50}$ was 72 nm. Next, the dispersion for polishing was obtained in the same manner as Example 1 using the zirconium oxide sol.

(Comparative Example 2)

The zirconium hydroxide in the amount of 3000 g obtained in the same manner as Example 1 was filled into a sheath made of cordierite, and baked in a batch-type electric heating furnace by maintaining the zirconium hydroxide for 10 hours at 400°C, to provide zirconium oxide. A mixture of 600 g of the zirconium oxide, 1400 g of ion exchange water and 12.0 g of 60% nitric acid was pulverized with a beads mill using a pulverization media made of zirconium oxide having a diameter of 0.3 mm, to provide zirconium oxide sol. The concentration of $ZrO_2$ of the sol was 20%, the pH was 3.1 and $D_{50}$ was 121 nm. Next, the dispersion for polishing was obtained in the same manner as Example 1 using the zirconium oxide sol.

(Comparative Example 3)

The zirconium hydroxide obtained in the same manner as Example 1 in the amount of 3000 g was filled into a sheath made of a cordierite, and baked in a batch-type electric heating furnace by maintaining the zirconium hydroxide for 10 hours at 1150°C, to provide zirconium oxide. A mixture of 600 g of the zirconium oxide, 1400 g of ion exchange water and 5.0 g of 60% nitric acid was pulverized with a beads mill using a pulverization media made of zirconium oxide having a diameter of 0.3 mm, to provide zirconium oxide sol. The concentration of $ZrO_2$ of the sol was 20%, the pH was 3.2 and $D_{50}$ was 236 nm. Next, the dispersion for polishing was obtained in the same manner as Example 1 using the zirconium oxide sol.

[Table 1]

Table 1 Results of powder X-ray diffraction measurement and analysis, and evaluation of polishing properties

| No. | Temperature of zirconium oxychloride aqueous solution (°C) | Ammonia water dropwise addition | | Crystalline side | Crystallite size (nm) | Ratio of crystallite size m (-111) / m (111) | Tetragonal ratio (%) | Ratio of crystallite size m (-111) / t (101) | Polishing rate (μm/h) | Surface roughness Ra (Å) | Surface defect (polarizing microscope) |
| | | Retention time after first step (min) | Retention time after second step (min) | | | | | | | | |
|---|---|---|---|---|---|---|---|---|---|---|---|
| Example 1 | 60 | 60 | 10 | m (-111) m (111) | 6.2 9.6 | 0.65 | 0 | - | 0.63 | 0.52 | ◎ |
| Example 2 | 75 | 60 | 10 | m (-111) m (111) | 10.2 14.0 | 0.73 | 0 | - | 0.91 | 0.46 | ◎ |
| Example 3 | 90 | 60 | 10 | m (-111) m (111) | 25.9 28.5 | 0.91 | 0 | - | 1.03 | 0.58 | ◎ |
| Example 4 | 75 | 90 | 10 | m (-111) m (111) | 9.2 14.6 | 0.63 | 0 | - | 1.07 | 0.45 | ◎ |
| Example 5 | 75 | 60 | 30 | m (-111) m (111) t (101) | 8.2 11.0 9.8 | 0.75 | 7.6 | 0.84 | 0.82 | 0.35 | ◎ |

[Table 2]

Table 2 Results of powder X-ray diffraction measurement and analysis, and evaluation of polishing properties

| No. | Temperature of zirconium oxychloride aqueous solution (°C) | Ammonia water dropwise addition | | Crystalline side | Crystallite size (nm) | Ratio of crystallite size m (-111) / m (111) | Tetragonal ratio (%) | Ratio of crystallite size m (-111) / t (101) | Polishing rate ($\mu$m/h) | Surface roughness Ra (Å) | Surface defect (polarizing microscope) |
|---|---|---|---|---|---|---|---|---|---|---|---|
| | | Retention time after first step (min) | Retention time after second step (min) | | | | | | | | |
| Example 6 | 75 | 60 | 60 | m (-111)<br>m (111)<br>t (101) | 8.0<br>10.8<br>10.4 | 0.74 | 18.9 | 0.77 | 0.90 | 0.38 | ◎ |
| Example 7 | 75 | 60 | 120 | m (-111)<br>m (111)<br>t (101) | 8.5<br>11.4<br>12.9 | 0.75 | 42.4 | 0.66 | 0.86 | 0.37 | ◎ |
| Comparative Example 1 | 25 | 10 | - | m (-111)<br>m (111) | 4.6<br>4.8 | 0.96 | 0 | - | 0.29 | 0.55 | Δ |
| Comparative Example 2 | 60 | 60 | 10 | m (-111)<br>m (111) | 10.4<br>10.8 | 0.96 | 0 | - | 0.34 | 1.13 | Δ |
| Comparative Example 3 | 60 | 60 | 10 | m (-111)<br>m (111) | 64.6<br>64.1 | 1.01 | 0 | - | 0.91 | 1.36 | × |

※

The resulting zirconium hydroxide was baked in Comparative Examples 2 and 3.

As shown in Tables 1 and 2, it is found that the polishing using the dispersion for polishing of each Examples results in products having excellent polishing rate and surface smoothness after polishing. In addition, it can be understood that the polishing in each Examples is a good polishing without surface defect. In addition, it is found that the surface roughness is lower in Examples 5 to 7 containing a tetragonal phase as compared to Example 2 not containing a tetragonal phase, and the smoothness is more excellent.

INDUSTRIAL APPLICABILITY

The dispersion for polishing and the powder for polishing of the present invention can be used in a chemical mechanical polishing (CMP) such as SiC wafer, and can be utilized in a production process of a semiconductor and the like.

**Claims**

1. A dispersion for polishing comprising a zirconium oxide and a polishing aid, wherein the zirconium oxide comprises a monoclinic phase, and has a ratio of crystallite size of a monoclinic (-111) side to a monoclinic (111) side ((-111) side / (111) side) of from 0.50 to 0.95.

2. The dispersion for polishing according to claim 1, wherein the crystallite size of each crystalline side of the zirconium oxide is from 2.0 to 100.0 nm.

3. The dispersion for polishing according to claim 1, wherein the zirconium oxide further comprises a tetragonal phase.

4. The dispersion for polishing according to claim 3, wherein a content of the tetragonal phase in the zirconium oxide is from 2.0 to 90.0% in a volume fraction.

5. The dispersion for polishing according to claim 3, wherein a ratio of crystallite size of a monoclinic (-111) side and a tetragonal (101) side ((-111) side / (101) side) in the zirconium oxide is from 0.30 to 1.20.

6. The dispersion for polishing according to claim 1, wherein the polishing aid comprises one or more kinds selected from the group consisting of a peroxide, a nitrate compound, a persulfate compound, a chlorine compound, a bromine compound, an iodine compound, a ferrate, a permanganate, a chromate, a vanadate, a ruthenate, a molybdate, a rhenic acid and a tungstic acid.

7. The dispersion for polishing according to claim 1 usable for polishing a SiC wafer.

8. A method for producing a dispersion for polishing comprising a zirconium oxide and a polishing aid: comprising preparing the dispersion using the zirconium oxide and the polishing aid, wherein the zirconium oxide comprises a monoclinic phase and has a ratio of crystallite size of a monoclinic (-111) side to a monoclinic (111) side ((-111) side / (111) side) of from 0.50 to 0.95.

9. A method for improving a polishing rate: comprising polishing using a zirconium oxide and a polishing aid, wherein the zirconium oxide comprises a monoclinic phase and has a ratio of crystallite size of a monoclinic (-111) side to a monoclinic (111) side ((-111) side / (111) side) of from 0.50 to 0.95.

10. A method for reducing a surface roughness Ra: comprising polishing using a zirconium oxide and a polishing aid, wherein the zirconium oxide comprises a monoclinic phase and has a ratio of crystallite size of a monoclinic (-111) side to a monoclinic (111) side ((-111) side / (111) side) of from 0.50 to 0.95.

11. A powder for polishing comprising a zirconium oxide powder, wherein the zirconium oxide powder comprises a monoclinic phase and has a ratio of crystallite size of a monoclinic (-111) side to a monoclinic (111) side ((-111) side / (111) side) of from 0.50 to 0.95.

12. The powder for polishing according to claim 11, wherein the crystallite size of each crystalline side of the zirconium oxide powder is from 2.0 to 100.0 nm.

13. The powder for polishing according to claim 11 or 12, wherein a mean secondary particle size of the zirconium oxide powder is from 0.002 to 5 $\mu$m.

14. The powder for polishing according to claim 13, wherein the mean secondary particle size of the zirconium oxide particle is 0.1 $\mu$m or less.

15. The powder for polishing according to claim 11, wherein a purity of the zirconium oxide powder is 97% by mass or more.

16. The powder for polishing according to claim 11, wherein the zirconium oxide powder is produced according to a wet method.

17. The powder for polishing according to claim 11, wherein a specific surface area of the zirconium oxide powder is 20 $m^2$/g or more.

# EP 4 715 022 A1

## INTERNATIONAL SEARCH REPORT

| | International application No. |
|---|---|
| | **PCT/JP2024/035804** |

### A. CLASSIFICATION OF SUBJECT MATTER

*C09K 3/14*(2006.01)i; *B24B 37/00*(2012.01)i; *C09G 1/02*(2006.01)i; *H01L 21/304*(2006.01)i
FI: C09K3/14 550D; B24B37/00 H; C09G1/02; C09K3/14 550Z; H01L21/304 622B

According to International Patent Classification (IPC) or to both national classification and IPC

### B. FIELDS SEARCHED

Minimum documentation searched (classification system followed by classification symbols)

C09K3/14; B24B37/00; C09G1/02; H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2010-105892 A (KANTO DENKA KOGYO CO., LTD.) 13 May 2010 (2010-05-13) claims, examples | 1-2, 8-17 |
| Y | | 3-7 |
| X | JP 2005-170700 A (HITACHI MAXELL LTD.) 30 June 2005 (2005-06-30) claims, examples 1, 3 | 1-2, 8-17 |
| Y | | 3-7 |
| Y | JP 2023-147178 A (FUJIMI INC.) 12 October 2023 (2023-10-12) claims, paragraphs [0026], [0061], examples 1, 4-10 | 3-7 |
| A | JP 2014-504324 A (SAINT-GOBAIN CERAMICS & PLASTICS, INC.) 20 February 2014 (2014-02-20) | 1-17 |

☐ Further documents are listed in the continuation of Box C.     ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **13 November 2024** | **03 December 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
**Information on patent family members**

International application No.

**PCT/JP2024/035804**

| Patent document<br>cited in search report | | | Publication date<br>(day/month/year) | Patent family member(s) | Publication date<br>(day/month/year) |
|---|---|---|---|---|---|
| JP | 2010-105892 | A | 13 May 2010 | (Family: none) | |
| JP | 2005-170700 | A | 30 June 2005 | (Family: none) | |
| JP | 2023-147178 | A | 12 October 2023 | US 2023/0312980 A1<br>claims, paragraphs [0026],<br>[0085], examples 1, 4-10<br>CN 116891724 A<br>KR 10-2023-0141967 A<br>TW 202342666 A | |
| JP | 2014-504324 | A | 20 February 2014 | US 2012/0171936 A1<br>WO 2012/092361 A2<br>EP 2658943 A2<br>TW 201226547 A<br>CN 103328598 A<br>KR 10-2013-0108433 A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006324639 A
- WO 2012169515 A
- JP 2023512216 A
- WO 2006123562 A